# EUROPEAN PATENT SPECIFICATION

(11) **EP 1 049 199 B1**
(45) Date of publication and mention of the grant of the patent: **14.06.2006**
(21) Application number: 00303541.7
(22) Date of filing: 27.04.2000
(51) Int. Cl.: H01R 11/18, H01R 13/58, H01R 13/646

(54) **Strain relief, pull-strength termination with controlled impedance for an electrical cable**
Zugentlastung-Zugkraft Abschluss mit gesteuerter Impedanz für ein elektrisches Kabel
Termination pour traction avec soulagement de tensions et impédance controlée, pour un cable électrique

(30) Priority: 28.04.1999 US 300980
(43) Date of publication of application: 02.11.2000
(73) Proprietor: TEKTRONIX, INC., Beaverton, OR 97077 (US)
(72) Inventor: Nightingale, Mark W., Washougal, Washington 98671 (US)
(74) Representative: Molyneaux, Martyn William

(56) References cited:
- US-A- 4 749 370
- US-A- 5 061 892
- US-A- 5 585 806

## Description

### BACKGROUND OF THE INVENTION

The present invention relates generally to terminations for transmission cables and more particularly to a strain relief pull-strength termination with controlled cable impedance usable in a measurement test probe.

A commonly used design for measurement test probes is an electrically conductive elongate body made of nickel plated brass having a substrate disposed therein. The substrate contains either passive or active circuitry to minimize probe loading and to terminate the probe in the characteristic impedance of the measuring device. The elongate electrically conductive body has a probing tip at one end that is secured in the body by an insulating plug. The probing tip extends through the insulating plug and is exposed within the conductive body. The substrate is electrically connected to the probing tip by electrically conductive elastomeric material or other such conventional connecting methods. Surrounding a substantial portion of the conductive body is an insulating material, such as injected molded plastic parts. Various methods are used for attaching the plastic parts to the tubular body, such as press fitting, gluing, or injection molding of the plastic directly onto the body. The plastic parts are generally formed with an outwardly extending flange that serves as a finger stop and guard. The plastic parts also serve as an outer housing for securing a transmission cable to the probe.

The transmission cable has a central conductor encased in an dielectric material and surrounded by an outer conductive shielding material. The outer conductive shielding material is covered by a insulating material. Generally, the outer shielding material is of finely braided wires. The central conductor is electrically connected to the substrate and the outer shielding material is electrically connected to the electrically conductive body. Many apparatus and methods are employed for connecting the transmission cable to the measurement test probe.

One such apparatus and method is described in US-A- 5,061,892, titled "Electrical Test Probe Having Integral Strain Relief and Ground Connection", and assigned to the assignee of the present invention. A strain relief adapter is provided that has a tubular shaped member and a flat surface portion that transitions from the tubular member. The flat surface portion is secured to the substrate of the measurement probe. The outer insulating material of the transmission cable is removed and the outer conductive shielding material is folded back over the outer insulating material and positioned in the tubular member of the strain relief. The substrate and strain relief adapter are inserted into the electrically conductive elongate body and the conductive body is crimped at the location of the tubular member of the strain relief adapter using an appropriate crimping tool to capture and secure the transmission cable within the electrically conductive elongate body.

US-A-3,828,298, titled "Electrical Terminal for a Braided Shied on a Coaxial Cable", describes and electrical terminal for grounding the braided shield of a coaxial cable. The terminal includes a generally U-shaped braided shield ferrule-forming portion and an integrally formed wire barrel. The wire barrel includes a base portion and a pair of upstanding sidewalls extend from opposite sides of the base portion. The U-shaped braided shield ferrule-forming portion includes a base portion and upstandin; sidewalls on either side of the base portion. A pair of lances are stamped out of each sidewalls and are integral with the base portion. A coaxial cable is prepared for the electrical terminal by removing a portion of the outer insulating jacket and exposing the braided shield. A portion of the exposed braided shield is removed to expose the insulating material surrounding the center conductor. A portion of the insulating material is removed to expose the center conductor. The prepared coaxial cable is aligned over the terminal with the exposed braided shield directly over the ferrule-forming portion. The coaxial cable is forced down onto the terminal with the lances piercing the braided shield. The sidewalls of the wire barrel and the ferrule-forming portion are respectively crimped around the insulating jacket and the braided shield.

US-A-5585806 discloses a flat antenna apparatus in which a circuit board supporting an antenna has the circuit board partially enclosed within a metal case and a portion of the circuit board extending outside the metal case partially supports a coaxial cable, an inner conductor of the cable being soldered to a termination on the circuit board. Tabs extend from the metal casing to secure the coaxial cable.

A major drawback to these and other similar types of design is that the coaxial cable or transmission cable is crimped, in part, to provide the strain relief and pull-strength on the cable. Such crimping causes changes in the characteristic impedance of the coaxial cable or transmission cable at the crimping location. The impedance changes in the coaxial cable adversely affect the overall bandwidth characteristics of the measurement test probe. With the bandwidth requirements of measurement test probes exceeding 3 GHZ, a new desing is needed for providing strain relief and pull-strength for transmission cables used with measurement test probes that does not affect the characteristic impedance of the transmission cable.

### SUMMARY OF THE INVENTION

According to a first aspect of this invention there is provided a strain relief and pull-strength termination as claimed in claim 1 herein.

According to a second aspect of this invention there is provided a probe head for a measurement probe as claimed in claim 4 herein.

Preferred features of the invention are defined by the dependent claims.

The objects, advantage and novel features of the present invention are apparent from the following detailed description when read in conjunction with appended claims and attached drawings.

### BRIEF DESCRIPTION OF THE DRAWINGS

Fig. 1 is an exploded perspective view of strain relief and pull-strength , termination with controlled cable impedance according to the present invention
Fig. 2 is a exploded perspective view of the probe head of a measurement probe incorporating the strain relief and pull-strength termination with controlled cable impedance according to the present invention.
Fig. 3 is a perspective view illustrating a probe head of a measurement probe incorporating the strain relief and pull-strength termination with controlled cable impedance according to the present invention.

### DETAILED DESCRIPTION OF THE PREFERRED EMBODIMENT

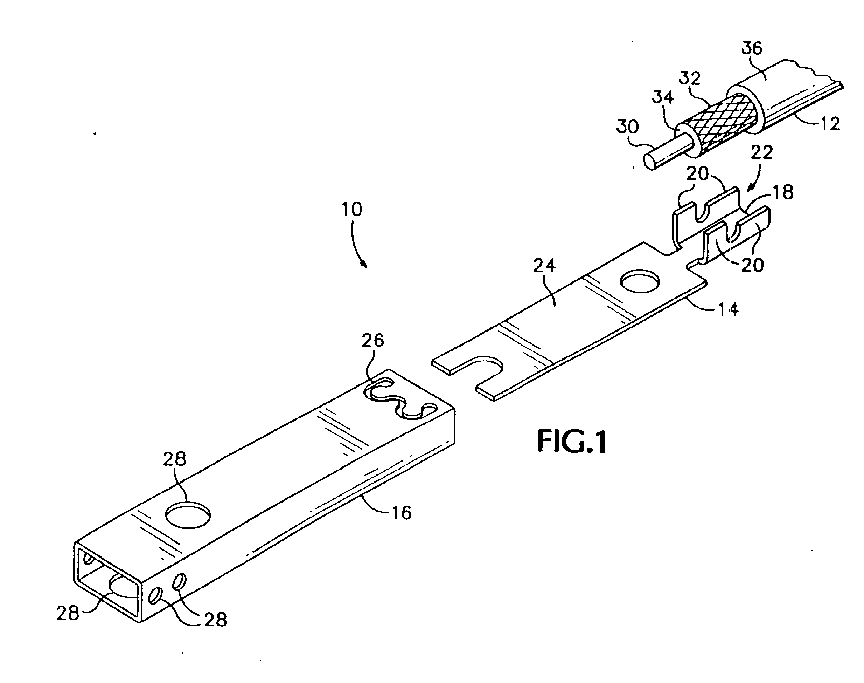

Referring to Fig. 1 there is shown an exploded perspective view of a strain relief and pull-strength termination with controlled cable impedance 10 for a transmission cable 12. The termination includes a carrier14 and a housing 16. The carrier includes at least one flat portion 18 for receiving the transmission cable 12 and at least one tab portion 20 extending from the flatportion 18 . In the preferred embodiment of the present invention, multiple tabs 20 extend upward from the opposite sides of the flat portion 18 forming a channel-like structure 22 for the transmission cable 12. Also in the preferred embodiment, the carrier 14 includes a flat portion 24 for accepting a substrate or the like to be described in greater detail below. The tabs 20 extending from the flat portion 18 of the carrier 12 may also extend laterally outward from the flat portion 18 forming a planar structure instead of the channel-like structure 22.

The housing 16 has a tab 26 formed therein that is bendable from a first position to a second position for engaging one or more of the tabs 20 on the carrier 14. The housing 16 may also have apertures 28 formed therein for providing access to components disposed within the housing 16. In the preferred embodiment of the invention, the housing 16 has an elongate rectangular shape. The shape of the housing 16 is not limited to the rectangular shape shown and other configuration are possibly, such as tubular, semicircular, or the like, without departing from the scope of the attached claims. Additionally, the strain relief and pull-strength termination with controlled cable impedance 10 of the present invention is not limited to a single tab 26 formed in the top of the housing 16 as shown in Figure 1. Alternate implementations of the invention include providing tabs 26 on opposite sides of the rectangular shaped housing 16 that engage the planar configured tabs 20 of the carrier 14.

The flat portion 18 of the carrier 14 receives the transmission cable 12. The termination 10 of the present invention will be shown and described using a coaxial cable as the transmission cable 12.

The transmission cable 12, in the form of a coaxial cable, has a center conductor 30 surrounded by a shielding conductor 32 with insulating material 34 separating the center conductor 30 from the shielding conductor 32. Surrounding the shielding conductor 32 is an outer insulating sheath 36. Generally, the shielding conductor 32 in a coaxial cable is made of many strands of fine wire braided together in one or more layers. The coaxial cable 12 is positioned in the carrier 14 with the braided shielding conductor 32 disposed in the channel-like structure 22. The shielding conductor 32 is secured to the carrier 14 by soldering which does not alter the characteristic impedance of the transmission cable 12.

The carrier 14 is positioned within the housing 16 with the tabs 20 of the carrier 14 extending past the tab 26 of the housing 16. The tab 26 is bent downward into the housing so that the tabs 20 engage the tab 26 when a pulling force is applied to the transmission cable 12. The interlocking tabs 20 and 26 provide the strain relief and pull strength for the transmission cable 12 without the need for crimping the cable within the housing 16 as is done with prior cable strain relief apparatus and methods.

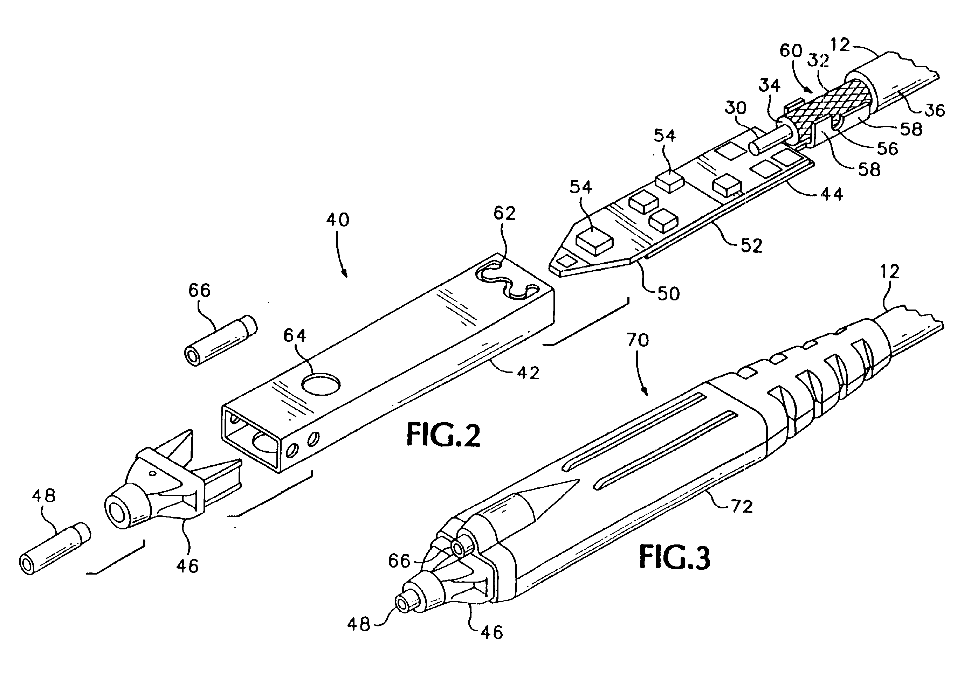

Referring to Fig. 2, there is shown an exploded perspective view of the strain relief and pull-strength termination 10 with controlled cable impedance incorporated into a probe head 40 of a measurement probe. The probe head 40 has an elongate electrically conductive housing 42 and a carrier 44 similar to the carrier and housing shown in Figure 1. Disposed within one end of the housing 42 is an plug 46 of insulating material having a probing tip 48 extending there through. One end of the probing tip 48 accepts a variety of probing adapters (not shown) for electrically connecting the probing tip to a device under test. The other end of the probing tip 48, which is exposed within the housing 42, is electrically connected to a substrate 50 secured to one of two flat portions 52 of the carrier 44. In the preferred embodiment of the present invention, the substrate 50 is secured to the carrier by soldering and glueing using an epoxy adhesive. Mounted on the substrate 50 are electrical components 54, such as passive resistor and capacitor components, and/or active components, such as integrated circuit and/or transistor, for compensating the probe and/or terminating the electrical signal output of the substrate 50 in the characteristic impedance of the transmission cable 12. Another flat portion 56 of the carrier 44 extends from the first flat portion 52 and has tabs 58 extending from either side of the flat portion 56. The second flat portion 56 and the tab portions 58 form a channel-like structure 60 for accepting the transmission cable 12.

The transmission cable 12 is prepared for the carrier 44 by removing a portion of the outer insulating sheath 36 from one end of the cable to expose the shielding conductor 32. A portion of the shielding conductor 32 and the insulating material 34 is removed from the end of the cable to expose the center conductor 30. The prepared end of the cable 12 is positioned on the carrier 44 with the exposed shielding conductor 32 disposed in the channel-like structure 60 formed by the second flat portion 56 and the tabs 58. The center conductor 30 is positioned on the substrate 50 and electrically connected to the electrical circuitry thereon. The shielding conductor 32 and the center conductor 30 are respectively soldered to the channel-like structure and the substrate 50.

The prepared assembly, consisting of the carrier 44, substrate 50 and transmission cable 12, is positioned within the housing 42 with the tabs 58 extending past tab 62 formed in the housing 42. The tab 62 is bent from its first formed positioned to a second position within the housing 42 for engaging the tabs 58 on the carrier 44. The tabs 58 and 62 are positioned in engaging contact and the carrier 44 and substrate are secured within the housing 42. In the preferred embodiment of the invention, the carrier 44 and substrate 50 are secured within the housing by soldering. Apertures 64 are formed in the housing 42 to allow access to the substrate 50 and components 52 thereon, for securing additional components to the substrate 50. For example, the large aperture 64 on the top of the housing 42 may be used for soldering the probing tip 48 to the substrate 50. Further, a second probing tip 66 may be connected to housing 42 or a ground contact on the substrate for providing a grounded probing tip on the probe head 40.

In the preferred embodiment of the invention, the housing 42 for the probe head is an elongate rectangular shaped tubular body formed of brass coaled with sulfimate-nickel having a thickness in the range of 2.54 µm to 3.08 µm (100 to 200 micro inches). The sides of the tubular body are nominally 0.312 cm and 0.635 cm (.125 inches and .250 inches) with a length in the range of 3.035 cm (1.195 inches). The walls of the tubular body have a nominal thickness of 0.036 cm (.014 inches) The tab 62 on the housing 42 is nominally positioned 2.68 cm (1.055 inches) from the front edge of the housing with the front edge as being defined as the end of the housing accepting the probing tip plug 46. The tab 62 is formed in the housing 42 using well known machining processes that produce a tab having a nominal width from side to side of 0.323 cm (.128 inches) and a length of 0.168 cm (.066 inches). The corners of the machined tab 62 are radiused for strain relief and the center portion of the tab 62 has an indentation formed therein having a nominal radius of 0.109 cm (.043 inches) forming mirrored tips on the tab 62.

The carrier 44 is formed from brass having a nominal thickness of 0.033 cm (.013 inches) and plated with gold having a nominal thickness from 0.076 µm to 6.2 µm (3 to 8 inches) over an electroless nickel having a nominal thickness of 0.00013 cm (.00005 inches) The carrier 44 has an over all length in the range of 2.46 cm (.970 inches) and a width of 0.43 cm (.170 inches). The flat portion 52 receiving the substrate 50 has a nominal length of 1.8 cm (.710 inches) and a width of 0.43 cm(.170) inches. The channel-like structure 60 that receives the transmission cable 12 may be integrally formed with the flat portion 52 as is done in the preferred embodiment The flat portion 56 of the channel-like structure 60 has a nominal width of 0.134 cm (.055 inches) and an overall length of 0.66 cm (.260 inches) The tabs 58 are formed on opposite sides of the flat portion 56 with one set of opposing tabs 58 starting at a nominal 0.1 cm (.040 inches) from the junction of the flat portions 52 and 56 and having a nominal height of 0.22 cm (.089 inches) from the bottom of the carrier 44. A second set of opposing tabs 58 have a nominal height 0.16 cm (.063 inches) from the bottom of the carrier 44. The two sets of tabs are separated from each other by a radiused opening having a radius of 0.06 cm (.025 inches).

Referring to Figure 3, there is shown a perspective view illustrating a probe head 70 of a measurement probe incorporating the strain relief and pull-strength termination with controlled cable impedance according to the present invention. Like elements from the previous figures are the same in Figure 3. The probe head 70 includes the probing tip 48 disposed in the insulating plug 46. The ground probing tip 66 is mounted on the housing adjacent to and in close proximity to the probing tip 48. Extending from the opposite end of the probe head 70 is the transmission cable 12. Insulating material 72 is formed around the housing 42, a substantial portion of the ground probe tip 66 and a portion of the transmission cable 12. The insulating material 72 electrically isolates the conductive elements of the probe head 70 and provides strain relief for the transmission cable 12 at the probe head 70 cable 12 interface. In the preferred embodiment of the invention, the insulating material is an injected molded part that is placed around the housing 42, ground probe tip 66 and the end of the transmission cable 12.

A strain relief and pull-strength termination with controlled impedance for a transmission cable has been described. The termination includes a carrier and a housing with each having tabs that interlock in the assembled position to provide the strain relief and pull-strength termination. The carrier has a flat portion and extending tab portions that form a channel-like structure for receiving the transmission cable. The transmission cable is prepared by exposing the shielding conductor of the cable, if present, and securing the cable to the carrier by soldering. The carrier is positioned within the housing and the housing tab is bent to engage the carrier tab. The interlocking tabs provides for the strain and pull-strength for the cable without having to crimp the cable within the housing. Thus the characteristic impedance of the cable is maintained. The strain relief and pull-strength termination with controlled impedance is usable in a probe head for an electrical measurement probe.

It will be obvious to those having skill in the art that many changes may be made to the details of the above-described embodiments of this invention without departing from the following claims.

## Claims

1. A strain relief and pull-strength termination of transmission cable (12) comprising:
an electrically conductive carrier (14, 44) having a flat portion (18, 56) and at least one tab portion (20, 58) extending from the flat portion with the flat portion accepting one end of the cable where the cable is a coaxial cable having a centre conductor (30) surrounded by a shielding conductor (32) with an insulating material (34) separating the centre conductor from the shielding conductor;
and **characterised by** :
a solder connection between the outer shielding conductor and the electrically conductive carrier that secures the cable to the carrier so that the characteristic impedance of the cable (12) is not attered and wherein
the carrier is disposed within a housing (16, 42) having a tab (26, 62) formed in the housing that is bendable from a first position in which the housing tab does not engage the carrier tab to a second positionin which the housing tab engages the carrier tab to retain the carrier (14, 44) within the housing (16, 42).

2. The strain relief and pull-strength termination as recited in claim 1, wherein the carrier further comprises a plurality of tab portions (20) extending from the flat portion.

3. The strain relief and pull-strength termination as recited in claim 2, wherein the flat portion (18) of the carrier has an axial dimension with the tab portions (20) extending upward from the flat portion to be parallel with the axial dimension.

4. A probe head (40) for a measurement probe having a strain relief and pull-strength termination of a transmission cable (12) according to one of the claims 1 to 3, the probe head (40) further comprising:
a substrate (50) secured to another flat portion (52) of the carrier (44) electrically connected to the transmission cable;
a probing tip (48) extending from the other end of the housing and electrically connected to the substrate (50).

5. The probe head as recited in claim 4, wherein the carrier further comprises a plurality of tab portions extending from the flat portion.

6. The probe head as recited in claim 5, wherein the carrier has an axial dimension with the tab portions extending upward from the flat portion to be parallel with the axial dimension.

7. The probe head as recited in claim 4 further comprising a body of insulating material(72) surrounding the housing and a portion of the cable extending from the housing.

## Patentansprüche

1. Zugentlastungs- und Zugkraftabschluss eines Übertragungskabels (12), wobei dieser folgendes umfasst:
einen elektrisch leitfähigen Träger (14, 44) mit einem flachen Teilstück (18, 56) und mindestens einem Ansatzteilstück (20, 58), das sich von dem flachen Teilstück erstreckt, wobei das flache Teilstück ein Ende des Kabels aufnimmt, wobei es sich bei dem Kabel um ein Koaxialkabel mit einem zentralen Leiter (30) handelt, der von einem abschirmenden Leiter (32) mit einem isolierenden Material (34) umgeben ist, welches den zentralen Leiter von dem abschirmenden Leiter trennt;
und **gekennzeichnet durch**:
eine Lötverbindung zwischen dem äußeren abschirmenden Leiter und dem elektrisch leitenden Träger, welche das Kabel an dem Träger sichert, so dass der Kennwiderstand des Kabels (12) nicht verändert wird; und wobei
der Träger in einem Gehäuse (16, 42) angeordnet ist, mit einem Ansatz (26, 62), der in dem Gehäuse ausgebildet ist, das aus einer ersten Position, an der der Gehäuseansatz nicht mit dem Trägeransatz eingreift, an eine zweite Position biegbar ist, an der der Gehäuseansatz mit dem Trägeransatz eingreift, so dass der Träger (14, 44) in dem Gehäuse (16, 42) gehalten wird.

2. Zugentlastungs- und Zugkraftabschluss nach Anspruch 1, wobei der Träger ferner eine Mehrzahl von Ansatzteilstücken (20) umfasst, die sich von dem flachen Teilstück erstrecken.

3. Zugentlastungs- und Zugkraftabschluss nach Anspruch 2, wobei das flache Teilstück (18) des Trägers eine axiale Abmessung aufweist, wobei die Ansatzteilstücke (20), die sich von dem flachen Teilstück nach oben erstrecken, parallel zu der axialen Abmessung sind.

4. Sondenkopf (40) für eine Messsonde mit einem Zugentlastungs- und Zugkraftabschluss eines Übertragungskabels (12) gemäß einem der Ansprüche 1 bis 3, wobei der Sondenkopf ferner folgendes umfasst:
ein Substrat (50), das an einem anderen flachen Teilstück (52) des Trägers (44) gesichert und elektrisch mit dem Übertragungskabel verbunden ist;
eine Sondenspitze (48), die sich von dem anderen Ende des Gehäuses erstreckt und mit dem Substrat (50) elektrisch verbunden ist.

5. Sondenkopf nach Anspruch 4, wobei der Träger ferner eine Mehrzahl von Ansatzteilstücken umfasst, die sich von dem flachen Teilstück erstrecken.

6. Sondenkopf nach Anspruch 5, wobei der Träger eine axiale Abmessung aufweist, wobei die sich von dem flachen Teilstück nach oben erstreckenden Ansatzteilstücke parallel zu der axialen Abmessung sind.

7. Sondenkopf nach Anspruch 4, wobei dieser ferner einen Körper aus einem isolierenden Material (72) umfasst, welcher das Gehäuse umgibt, und wobei sich ein Teilstück des Kabels von dem Gehäuse erstreckt.

## Revendications

1. Raccordement avec soulagement de tensions et résistance à l'arrachage d'un câble de transmission (12) comprenant :
un support électriquement conducteur (14, 44) ayant une partie plate (18, 56) et au moins une partie de tablette (20, 58) s'étendant depuis la partie plate, la partie plate acceptant une extrémité du câble, dans lequel le câble est un câble coaxial ayant un conducteur central (30) entouré par un conducteur de blindage (32) avec un matériau isolant (34) séparant le conducteur central du conducteur de blindage ;
et **caractérisé par** :
une connexion soudée entre le conducteur de blindage extérieur et le support électriquement conducteur qui fixe le câble au support afin que l'impédance caractéristique du câble (12) ne soit pas modifiée ; et dans lequel
le support est disposé à l'intérieur d'un boîtier (16, 42) ayant une languette (26, 62) formée dans le boîtier qui est pliable depuis une première position dans laquelle la languette du boîtier ne vient pas en prise avec la languette du support vers une seconde position dans laquelle la languette du boîtier vient en prise avec la languette du support pour retenir le support (14, 44) à l'intérieur du boîtier (16, 42).

2. Raccordement avec soulagement de tensions et résistance à l'arrachage selon la revendication 1, dans lequel le support comprend en outre une pluralité de parties de languette (20) s'étendant depuis la partie plate.

3. Raccordement avec soulagement de tensions et résistance à l'arrachage selon la revendication 2, dans lequel la partie plate (18) du support a une dimension axiale avec les parties de languette (20) s'étendant vers le haut depuis la partie plate pour être parallèles à la dimension axiale.

4. Tête de sonde (40) pour une sonde de mesure ayant un raccordement avec soulagement de tensions et résistance à l'arrachage d'un câble de transmission (12) selon l'une des revendications 1 à 3, la tête de sonde (40) comprenant en outre :
un substrat (50) fixé à une autre partie plate (52) du support (44) et électriquement relié au câble de transmission ;
une pointe de sonde (48) s'étendant depuis l'autre extrémité du boîtier et électriquement reliée au substrat (50) .

5. Tête de sonde selon la revendication 4, dans laquelle le support comprend en outre une pluralité de parties de languette s'étendant depuis la partie plate.

6. Tête de sonde selon la revendication 5, dans laquelle le support a une dimension axiale, les parties de languette s'étendant vers le haut depuis la partie plate pour être parallèles à la dimension axiale.

7. Tête de sonde selon la revendication 4, comprenant en outre un corps de matériau isolant (72) entourant le boîtier et une partie du câble s'étendant depuis le boîtier.
